# EUROPÄISCHE PATENTSCHRIFT

(11) **EP 4 439 106 B1**
(45) Veröffentlichungstag und Bekanntmachung des Hinweises auf die Patenterteilung: **02.07.2025**
(21) Anmeldenummer: 23164780.1
(22) Anmeldetag: 28.03.2023
(51) Int. Cl.: G01R 33/36, G01R 33/567, G01R 33/565

(54) **SENDEVORRICHTUNG ZUM ERZEUGEN EINES MEHRFREQUENZ-PILOTTONS SOWIE MAGNETRESONANZTOMOGRAPH MIT SENDEVORRICHTUNG**
TRANSMITTING DEVICE FOR GENERATING A MULTI-FREQUENCY PILOT TONE, AND MAGNETIC RESONANCE TOMOGRAPH COMPRISING A TRANSMITTING DEVICE
DISPOSITIF D'ÉMISSION POUR GÉNÉRER UN SIGNAL DE PILOTE MULTIFRÉQUENCE ET TOMOGRAPHE À RÉSONANCE MAGNÉTIQUE DOTÉ DU DISPOSITIF D'ÉMISSION

(43) Veröffentlichungstag der Anmeldung: 02.10.2024
(73) Patentinhaber: Siemens Healthineers AG, 91301 Forchheim (DE)
(72) Erfinder: Bollenbeck, Jan, 91330 Eggolsheim (DE)
(74) Vertreter: Siemens Healthineers Patent Attorneys

(56) Entgegenhaltungen:
- EP-A1- 3 895 610
- US-A1- 2022 361 822
- LUDWIG JULIANE ET AL: "Pilot tone-based motion correction for prospective respiratory compensated cardiac cine MRI", MAGNETIC RESONANCE IN MEDICINE, vol. 85, no. 5, 23 November 2020 (2020-11-23), US, pages 2403 - 2416, XP093001018, ISSN: 0740-3194, Retrieved from the Internet <URL:https://onlinelibrary.wiley.com/doi/full-xml/10.1002/mrm.28580> [retrieved on 20230905], DOI: 10.1002/mrm.28580

## Beschreibung

*Unabhängig vom grammatikalischen Geschlecht eines bestimmten Begriffes sind Personen mit männlicher, weiblicher oder anderer Geschlechteridentität mit umfasst.*

Magnetresonanztomographen sind bildgebende Vorrichtungen, die zur Abbildung eines Untersuchungsobjektes Kernspins des Untersuchungsobjektes mit einem starken äußeren Magnetfeld ausrichten und durch ein magnetisches Wechselfeld zur Präzession um diese Ausrichtung anregen. Die Präzession bzw. Rückkehr der Spins aus diesem angeregten in einen Zustand mit geringerer Energie wiederum erzeugt als Antwort ein magnetisches Wechselfeld, das über Antennen empfangen wird.

Mit Hilfe von magnetischen Gradientenfeldern wird den Signalen eine Ortskodierung aufgeprägt, die nachfolgend eine Zuordnung von dem empfangenen Signal zu einem Volumenelement ermöglicht. Das empfangene Magnetresonanzsignal wird dann ausgewertet und eine dreidimensionale bildgebende Darstellung des Untersuchungsobjektes bereitgestellt.

Die Magnetresonanzsignale sind sehr schwach. Um ein ausreichend hohes Signal-zu-Rausch-Verhältnis zu erzielen, ist daher das Signal über eine lange Zeit zu erfassen, in einer oder in wiederholten Messungen. Die Erfassung der Magnetresonanzsignale ist dabei langsam im Vergleich zu unvermeidbaren Bewegungen des Patienten wie Herzschlag oder Atembewegung. Die Bewegungen verursachen dabei Artefakte in den erzeugten Abbildungen.

Eine Möglichkeit, die bewegten Organe abzubilden besteht dennoch, wenn eine kurze Bilderfassung synchronisiert zu der Bewegung wiederholt ausgeführt wird und über die erfassten Daten mittelt.

Eine Synchronisierung kann mit dedizierten Sensoren wie beispielsweise Atemgurt oder EKG-Elektroden erfolgen.

Um diese zusätzlichen Sensoren zu vermeiden, ist es auch schon aus der Druckschrift US 2015/0320342 A1 bekannt, ein kontinuierliches, monofrequentes Magnetwechselfeld von einer kleinen Leiterschleife ausgehend, zumindest teilweise durch den Körper des Patienten hindurch in die einzelnen Elemente einer MR Lokalspule zu koppeln.

Die Druckschrift US 2022/361822 A1 beschreibt ein Verfahren und ein System zum Erkennen von Bewegungen eines Objektes in einem Magnetresonanztomographiegerät. Das Magnetresonanztomographiegerät weist ein paralleles Sendesystem auf, das dazu geeignet ist, MagnetresonanzAnregungsimpulse über ein HF-Sendespulenarray zu senden. Das Magnetresonanztomographiegerät weist weiterhin ein Empfangssystem auf, das dazu geeignet ist, Magnetresonanzsignale über ein HF-Empfangsspulenarray zu empfangen. In einem Schritt des Verfahrens wird eine Magnetresonanzuntersuchung durch Ausführen eines programmierbaren Magnetresonanzsequenzprotokolls ausgeführt, wobei das Sequenzprotokoll über das parallele Sendesystem zu sendende Magnetresonanzanregungsimpulse sowie Empfangszeitfenster zum Empfangen von Magnetresonanzsignalen über das Empfangssystem umfasst. Das Magnetresonanzsequenzprotokoll weist zwischen den Magnetresonanzanregungsimpulsen die Erzeugung von mehrkanaligen Pilottonsignalen auf, die über das parallele Sendesystem und das HF-Sendespulenarray gesendet werden. Während des Sendens der mehrkanaligen Pilottonsignale werden die Pilottonsignale mit dem HF-Empfangsspulenarray empfangen, über das Empfangssystem an eine Analyseeinheit weitergeleitet und eine Bewegung von mindestens einem Teil des Subjekts durch Analysieren des empfangenen Pilottonsignals an der Analyseeinheit bestimmt.

Da die meisten biologischen Gewebe fast vollständig transparent für Magnetfelder sind, durchdringt das erzeugte Magnetfeld den Körper des Patienten fast unverändert. Die meisten Gewebe sind jedoch (schwach) leitend und daher induziert das kontinuierliche Wellenmagnetfeld Wirbelströme. Diese Wirbelströme erzeugen dann wiederum ein Magnetfeld, das das Anregungsfeld überlagert, was zu Modulationen im empfangenen Magnetfeld in der Empfangsspule führt.

Durch Auswertung dieses Signals kann auf eine Bewegungsphase des Herzens oder der Atmung geschlossen werden.

Bei Verwendung eines Pilottonsignals kann es aber vorkommen, dass die empfangenen Signale und damit auch die durch die Bewegung verursachten Amplitudenschwankungen sehr schwach und kaum auszuwerten sind. Auch kann es vorkommen, dass der Anteil des Magnetwechselfeldes, welches durch den Herzschlag bewegtes Gewebe durchdringt, zu gering ist und das demodulierte Empfangssignal auch in diesem Fall ein zu geringes Signal-zu-Rauschverhältnis aufweist.

Es ist daher eine Aufgabe der vorliegenden Erfindung, das Erfassen von Bewegungen des Patienten besser und zuverlässiger zu machen.

Die Aufgabe wird durch eine erfindungsgemäße Sendevorrichtung nach Anspruch 1 und einen erfindungsgemäßen Magnetresonanztomographen nach Anspruch 7 gelöst. Die Sendevorrichtung ist eine Sendevorrichtung für ein Pilottonsignal. Als Pilottonsignal wird hier insbesondere ein Magnetwechselfeld angesehen, das geeignet ist, Wirbelströme im interessierenden Körpervolumen anzuregen, wodurch wiederum Magnetwechselfelder entstehen, die sich dem Sendefeld überlagern und die interessierende Bewegungsinformation tragen.

Vorzugsweise liegt das Pilottonsignal in einem Frequenzbereich bzw. Empfangsbereich, der durch Empfänger eines Magnetresonanztomographen für Magnetresonanzsignale erfasst und ausgewertet werden kann. Insbesondere ist der Frequenzbereich nicht breiter als ein Magnetresonanzsignal, also kleiner als 1 MHz, 500 kHz oder 100 kHz. Vorzugsweise ist das Pilottonsignal so schmalbandig, dass es an einem Randbereich des Frequenzbereichs des Empfängers liegend gleichzeitig mit einem Magnetresonanzsignal empfangen werden kann, ohne mit diesem zu überlappen und die Bilderfassung zu stören. Dann ist die Bandbreite vorzugsweise kleiner als 10 kHz, 1 kHz oder 500 Hz.

Die Sendevorrichtung ist ausgebildet, das Pilottonsignal mit einer Mehrzahl an diskreten Frequenzkomponenten zu erzeugen. Mit anderen Worten, ein Spektrum des Pilottons weist zumindest zwei voneinander getrennte lokale Maxima bei unterschiedlichen Frequenzen auf. Das Pilottonsignal ist also kein breitbandiges Signal, dessen Spektrum sich ohne ausgeprägte Maxima über einen Frequenzbereich erstreckt. Das Pilottonsignal kann beispielsweise auch ein Summensignal aus zwei oder mehr monochromatischen Hochfrequenzsignalen sein. Als Bandreite des Pilottonsignals wird dabei der Abstand der am weitesten im Frequenzraum voneinander entfernten Komponenten angesehen.

Die Sendevorrichtung weist eine Frequenzstabilisierungseinheit auf. Eine Frequenzstabilisierungseinheit ist eine Einheit, die ausgebildet ist, eine Frequenzdifferenz zwischen der Mehrzahl der Frequenzkomponenten konstant zu halten. Dies kann beispielsweise wie nachfolgend zu den Unteransprüchen erläutert, erzielt werden, indem eine oder mehrere Frequenzkomponenten nahe an der Frequenz eines Referenzsignals liegen und deren Frequenzabstand zur Frequenz des Referenzsignals jeweils konstant gehalten wird.

Auf vorteilhafte Weise werden durch die Frequenzkomponenten zusätzliche Koppelpfade aufgespannt, deren Beiträge aufgrund der spektralen Trennung einzeln ausgewertet werden können, was in Summe zu einem erhöhten SNR im demodulierten Empfangssignal führt. Dabei stellt die Frequenzstabilisierung sicher, dass alle Frequenzkomponenten des Pilottonsignals auf vorbestimmten Frequenzen bleiben, die die Bilderfassung nicht stören.

In dem erfindungsgemäßen Magnetresonanztomographen mit einer erfindungsgemäßen Sendevorrichtung werden die einzelnen Pilottonsignal Frequenzkomponenten vorzugsweise von räumlich voneinander getrennt angeordneten Magnetfeldschleifen gekoppelt. So werden zusätzliche Koppelpfade aufgespannt, deren Beiträge aufgrund der spektralen Trennung einzeln ausgewertet werden können, was in Summe zu einem erhöhten SNR im demodulierten Empfangssignal führt.

Der erfindungsgemäße Magnetresonanztomograph mit einer erfindungsgemäßen Sendevorrichtung teilt die Vorteile der erfindungsgemäßen Sendevorrichtung.

Weitere vorteilhafte Ausführungsformen sind in den Unteransprüchen angegeben.

In einer denkbaren Ausführungsform der erfindungsgemäßen Sendevorrichtung weist die Sendevorrichtung einen Signaleingang für ein erstes Eingangssignal auf. Als Eingangssignal werden insbesondere hochfrequente Signale angesehen, die einen Frequenzbezug bzw. eine Frequenzreferenz geben. Die Frequenzstabilisierungseinheit ist dabei ausgebildet, die Frequenzdifferenz der Frequenzkomponenten in Abhängigkeit von dem Eingangssignal zu stabilisieren. Denkbar ist beispielsweise, dass das Eingangssignal selbst als eine Frequenzkomponente dient und eine zweite oder weitere Frequenzkomponenten daraus abgeleitet werden. Verschiedene Möglichkeiten dazu sind nachfolgend dargelegt.

Durch das Eingangssignal ist es möglich, eine Frequenz vorzugeben, die durch eine zentrale Uhr stabilisiert ist und eine Beeinträchtigung der Magnetresonanzmessung durch z.B. Oberwellen aufgrund der entsprechend vorbestimmten und stabilen Frequenzlage verhindert.

In einer möglichen Ausführungsform der erfindungsgemäßen Sendevorrichtung weist die Frequenzstabilisierungseinheit eine Regelschleife mit einer Frequenz-Offset-Stabilisierung auf. Mit anderen Worten, es wird eine zweite Frequenzkomponente erzeugt und durch eine Regelschleife in ihrem Frequenzabstand zur Referenzfrequenz, beispielsweise dem Eingangssignal oder einer davon abgeleiteten ersten Frequenzkomponente stabilisiert. Bei drei oder mehr zu erzeugenden bzw. zu stabilisierenden Frequenzkomponenten können mehrere entsprechende Regelschleifen vorgesehen sein, für jede zusätzliche Frequenzkomponente eine.

Auf vorteilhafte Weise lassen sich so auch Signale mit geringem Frequenzabstand frequenzstabilisieren.

In einer denkbaren Ausführungsform der erfindungsgemäßen Sendevorrichtung weist die Frequenz-Offset-Stabilisierung einen Frequenz-Spannungswandler, einen Integrator und einen spannungsgesteuerten Oszillator auf. Der Integrator kann beispielsweise ein Komparator bzw. Operationsverstärker sein, der im Gegenkopplungszweig eine Kapazität aufweist bzw. über diese die Gegenkopplung vornimmt.

Auf vorteilhafte Weise ermöglicht die Regelschleife über einen Frequenz-Spannungswandler und den spannungsabhängigen Oszillator im Gegensatz zu einer Phasenregelschaltung eine Frequenzstabilisierung ohne Nebenlinien bzw. Spurious-Signale.

In einer möglichen Ausführungsform der erfindungsgemäßen Sendevorrichtung weist die Regelschleife einen Oszillator auf. Es kann sich dabei auch um den bereits genannten spannungsabhängigen Oszillator handeln. Der Oszillator ist ausgebildet, auf einer Frequenz gleich einem ungeradzahligen Teiler der Frequenz des Ausgangssignals zu schwingen.

Auf vorteilhafte Weise kann ein Oszillator mit niedrigerer Grundfrequenz mit Quarzen auf der Grundfrequenz realisiert werden, die vorteilhafte Eigenschaften bezüglich Frequenzstabilität und Regelverhalten aufweisen. Die Frequenz der zweiten Frequenzkomponente kann dann durch Frequenzvervielfachung bereitgestellt werden.

In einer möglichen Ausführungsform der erfindungsgemäßen Sendevorrichtung weist die Regelschleife einen Steuereingang auf. Über den Steuereingang lässt sich die Regelschleife unterbrechen bzw. in einen Zustand versetzen, bei dem eine Ausgangsfrequenz für eine Dauer der Unterbrechung weitgehend unverändert bleibt. Beispielsweise könnte eine Regelspannung der Schleife durch ein Sample-and-Hold-Glied konstant gehalten werden.

Durch den Steuereingang kann vermieden werden, dass während eines Anregungspulses die Regelschleife gestört und außer Kontrolle gerät.

In einer denkbaren Ausführungsform des erfindungsgemäßen Magnetresonanztomographen ist der Magnetresonanztomograph ausgebildet, der Sendevorrichtung ein Eingangssignal mit einer vorbestimmten Frequenz zuzuführen, sodass das Eingangssignal und die davon abgeleiteten Frequenzkomponenten einen Empfang der Magnetresonanzsignale nicht stören. Dies kann beispielsweise durch eine derartige Wahl der vorbestimmten Frequenz erreicht werden, dass deren Oberwellen und die Oberwellen der davon abgeleiteten Signale nicht in den Frequenzbereich des zu empfangenden Magnetresonanzsignal des Magnetresonanztomographen fallen. Vorzugsweise ist die vorbestimmte Frequenz von einem zentralen Taktgeber des Magnetresonanztomographen abgeleitet.

Auf vorteilhafte Weise stellen die geeignete Frequenzwahl und die stabile Frequenzbeziehung sicher, dass das Pilottonsignal die bildgebenden Magnetresonanzsignale nicht stört und Artefakte hervorruft.

In einer möglichen Ausführungsform des erfindungsgemäßen Magnetresonanztomograph ist der Magnetresonanztomograph ausgebildet, während des Aussendens eines Anregungspulses für Kernspins ein Steuersignal an den Steuereingang anzulegen, das die Phasenregelschleife unterbricht.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Es zeigen:
- Fig. 1: eine schematische Darstellung eines Magnetresonanztomographen mit einer erfindungsgemäßen elektronischen Vorrichtung;
- Fig. 2: eine schematische Darstellung einer möglichen Ausführungsform einer erfindungsgemäßen Sendevorrichtung;
- Fig. 3: eine schematische Darstellung einer möglichen Ausführungsform einer erfindungsgemäßen Sendevorrichtung.

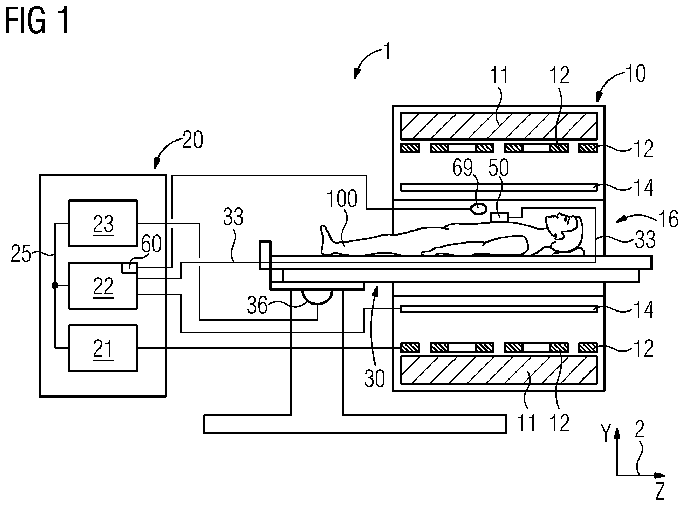

Fig. 1 zeigt eine schematische Darstellung einer Ausführungsform eines erfindungsgemäßen Magnetresonanztomographen 1 mit einer erfindungsgemäßen Sendevorrichtung.

Die Magneteinheit 10 weist einen Feldmagneten 11 auf, der ein statisches Magnetfeld B0 zur Ausrichtung von Kernspins von Proben bzw. des Patienten 100 in einem Aufnahmebereich erzeugt. Der Aufnahmebereich zeichnet sich durch ein äußerst homogenes statisches Magnetfeld B0 aus, wobei die Homogenität insbesondere die Magnetfeldstärke bzw. den Betrag betrifft. Der Aufnahmebereich ist nahezu kugelförmig und in einem Patiententunnel 16 angeordnet, der sich in einer Längsrichtung 2 durch die Magneteinheit 10 erstreckt. Eine Patientenliege 30 ist in dem Patiententunnel 16 von der Verfahreinheit 36 bewegbar. Üblicherweise handelt es sich bei dem Feldmagneten 11 um einen supraleitenden Magneten, der magnetische Felder mit einer magnetischen Flussdichte von bis zu 3T, bei neuesten Geräten sogar darüber, bereitstellen kann. Für geringere Magnetfeldstärken können jedoch auch Permanentmagnete oder Elektromagnete mit normalleitenden Spulen Verwendung finden.

Weiterhin weist die Magneteinheit 10 Gradientenspulen 12 auf, die dazu ausgelegt sind, zur räumlichen Differenzierung der erfassten Abbildungsbereiche in dem Untersuchungsvolumen dem Magnetfeld B0 zeitlich und räumlich variable Magnetfelder in drei Raumrichtungen zu überlagern. Die Gradientenspulen 12 sind üblicherweise Spulen aus normalleitenden Drähten, die zueinander orthogonale Felder in dem Untersuchungsvolumen erzeugen können.

Die Magneteinheit 10 weist ebenfalls eine Körperspule 14 auf, die dazu ausgelegt ist, ein über eine Signalleitung zugeführtes Hochfrequenzsignal in das Untersuchungsvolumen abzustrahlen und von dem Patient 100 emittierte Resonanzsignale zu empfangen und über eine Signalleitung abzugeben.

Eine Steuereinheit 20 versorgt die Magneteinheit 10 mit den verschiedenen Signalen für die Gradientenspulen 12 und die Körperspule 14 und wertet die empfangenen Signale aus.

So weist die Steuereinheit 20 eine Gradientenansteuerung 21 auf, die dazu ausgelegt ist, die Gradientenspulen 12 über Zuleitungen mit variablen Strömen zu versorgen, welche zeitlich koordiniert die erwünschten Gradientenfelder in dem Untersuchungsvolumen bereitstellen.

Weiterhin weist die Steuereinheit 20 eine Hochfrequenzeinheit 22 auf, die ausgelegt ist, einen Hochfrequenz-Puls mit einem vorgegebenen zeitlichen Verlauf, Amplitude und spektraler Leistungsverteilung zur Anregung einer Magnetresonanz der Kernspins in dem Patienten 100 zu erzeugen. Dabei können Pulsleistungen im Bereich von Kilowatt erreicht werden. Die Anregungssignale können über die Körperspule 14 oder auch über eine lokale Sendeantenne in den Patienten 100 abgestrahlt werden.

Eine Steuerung 23 kommuniziert über einen Signalbus 25 mit der Gradientensteuerung 21 und der Hochfrequenzeinheit 22.

Zum Empfang des Magnetresonanzsignals ist eine erfindungsgemäße Lokalspule 50 auf dem Patienten 100 im Patiententunnel 16 angeordnet, um Magnetresonanzsignale aus einem Untersuchungsbereich in unmittelbarer Nähe mit möglichst großem Rauschabstand zu erfassen. Die Lokalspule 50 ist über eine Anschlussleitung 33 mit einem Empfänger in der Hochfrequenzeinheit 22 in Signalverbindung.

Die erfindungsgemäße Sendevorrichtung ist vorzugsweise Teil der Hochfrequenzeinheit 22 und ist zu den nachfolgenden Figuren näher dargestellt.

Die Sendevorrichtung 60 sendet das Pilottonsignal über eine oder mehrere Antennen 69 des Magnetresonanztomographen 1 in den Körper des Patienten 100 ab. Üblicherweise sind die Antennen 69 als Induktionsspulen bzw. Magnetfeld-Koppelschleifen ausgebildet. Die Antenne bzw. Antennen 69 sind dabei vorzugsweise in der Nähe der zu erfassenden Organbewegungen angeordnet, beispielsweise am Oberbauch oder unter dem Brustkorb. Die Antenne 69 kann dabei auch in eine Spine Coil oder andere Lokalspule 50 integriert sein. Über mehrere verteilte Antennen 69 mit räumlicher Verteilung kann erreicht werden, dass zusätzliche Koppelpfade durch die durch den Herzschlag bewegte Körperregion aufgespannt werden. Da die Signale aufgrund ihres Frequenzabstandes zueinander in den Empfängern getrennt gesendet und verarbeitet werden können, ergibt sich aufgrund der so zusätzlich gewonnenen Information ein verbessertes SNR im demodulierten Empfangssignal. Es kann sozusagen die Ausleuchtung mit dem Pilottonsignal verbessert werden, sodass zumindest immer eines der Signale von einer der Antennen 69 mit ausreichender Stärke und Modulation durch die Bewegung von der Lokalspule 50 erfasst werden kann.

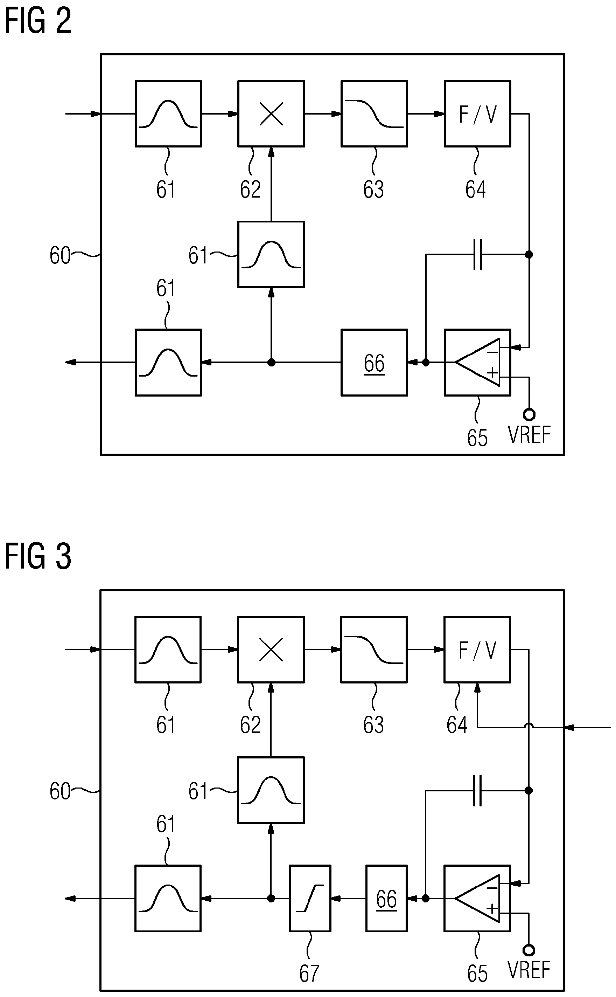

Fig. 2 zeigt eine schematische Darstellung einer möglichen Ausführungsform einer erfindungsgemäßen Sendevorrichtung. In der Ausführungsform wird der Sendevorrichtung ein erstes Eingangssignal zugeführt, das vorzugsweise von einem zentralen Taktgeber abgeleitet wird, der auch die Frequenzen für Anregungspulse für die Kernspins als auch für Misch- und/oder Abtastfrequenzen des Empfangspfades vorgibt. Das erste Eingangssignal gibt damit auch gleichzeitig die Frequenz für die erste Frequenzkomponente des Pilottonsignals vor. Die Frequenz des Eingangssignals wird derart ausgewählt, dass deren Harmonische in keines der MRT-Empfangsbänder und in keines der Aliasbänder der nachfolgenden Abtastung fallen. Der Abstand zwischen den einzelnen Pilottonsignal-Frequenzen wird zudem derart klein ausgewählt, dass die an potenziell vorhandenen Nichtlinearitäten des Empfangspfades entstehenden Intermodulationsprodukte, die aufgrund ihrer niedrigen Ordnungszahl einen störend großen Pegel aufweisen könnten, nicht in das MRT-Empfangsband fallen können.

Beispielhaft sind hier Frequenzwerte für einen Magnetresonanztomographen mit einer Magnetfeldstärke B0 von 1.5 T angegeben. Die Larmorfrequenz liegt dann bei 63,6 MHz. Wird dieses Signal mit einer Abtastrate von 10MS/s abgetastet, so kann das erste Eingangssignal dann beispielsweise mit einer Frequenz von 62,5 MHz gewählt werden.

Nach einer Filterung durch einen Bandpass-Filter 61 wird das erste Eingangssignal mit einem Mischer 62 zugeführt, der das erste Eingangssignal mit einem Oszillator-Signal mischt. Das Oszillator-Signal gibt dabei die Frequenz für die zweite Frequenzkomponente des Pilottonsignals an und ist Teil der Regelschleife zur Stabilisierung des Frequenzabstandes. Die Erzeugung wird im Folgenden erläutert.

Durch die Mischung des Oszillatorsignals mit dem ersten Eingangssignals werden Mischprodukte mit Frequenzen erzeugt, die der Summe und der Differenz der Frequenzen der beiden Signal entspricht. Mittels eines Tiefpass-Filters 63 wird dabei der Differenz-Wert herausgefiltert, d.h. das Mischsignal mit einer Frequenz im Bereich von Hertz bis kHz, wobei der Frequenzwert auch dem Frequenzabstand von erster Frequenzkomponente und zweiter Frequenzkomponente des Pilottonsignals entspricht. Im konkreten Zahlenbeispiel ist der Frequenzabstand mit 100 Hz gewählt.

Anschließend wird das Mischsignal einem Frequenz-Spannungswandler 64 zugeführt, der mit einer monoton steigenden oder monoton fallenden Kennlinie eine zur Frequenz korrespondierenden Spannung als Ausgangssignal liefert.

In einem Integrator 65 bzw. Operationsverstärker wird die erzeugte Spannung mit einer Referenzspannung verglichen und die Differenz aufsummiert bzw. integriert, wobei die Referenzspannung den Frequenzabstand vorgibt. Der Integrator 65 weist eine Gegenkopplung über einen Kondensator auf, die auch eine Schwingung des Regelkreises zu verhindern. Bei einer Abweichung gibt der Integrator 65 ein Regelspannung aus, die einem spannungsgesteuerten Oszillator 66 zuführt. Das Ausgangssignal des Oszillators 66 wird über einen Bandpassfilter 61 dem Mischer 62 zugeführt, um die Regelschleife zu schließen.

Die Regelschleife zur Frequenz-Offset-Stabilisierung weist also vorzugsweise den Frequenz-Spannungswandler 64, den Integrator 65 und einen spannungsgesteuerten Oszillator 66 auf. Der Mischer 62 sorgt dafür, dass durch die Differenzbildung der Frequenzen die Regelgenauigkeit verbessert wird.

Gleichzeitig wird über einen Bandpass-Filter 61 das Signal des Oszillators 66 spektral gefiltert und als zweite Frequenzkomponente des Pilottonsignals ausgegeben. Über die Regelschleife wird dabei die Frequenz der zweiten Frequenzkomponente im Frequenzabstand zu der ersten Frequenzkomponente konstant gehalten.

Die erste Frequenzkomponente und die zweite Frequenzkomponente werden in vorteilhafter Weise jeweils zugeordneten Magnetfeld Koppel-Schleifen als Antennen 69 zugeführt, die räumlich getrennt voneinander angeordnet werden. Durch die räumliche Trennung kann erreicht werden, dass zusätzliche Koppelpfade durch die durch den Herzschlag bewegte Körperregion aufgespannt werden. Da die Signale aufgrund ihres Frequenzabstandes zueinander in den Empfängern getrennt verarbeitet werden können, ergibt sich aufgrund der so zusätzlich gewonnenen Information ein verbessertes SNR im demodulierten Empfangssignal.

Fig. 3 zeigt eine weitere mögliche Ausführungsform der erfindungsgemäßen Sendevorrichtung 60. Gleiche Referenzzeichen bezeichnen gleiche Gegenstände und es gilt das zur Fig. 2 ausgeführte.

Der Gegenstand der Fig. 3 unterscheidet sich von dem Gegenstand der Fig. 2 dadurch, dass der Oszillator nicht unmittelbar auf der zu erzeugenden Frequenz von 62,5 MHz schwingt. spannungsgesteuerte Oszillatoren lassen sich am besten mit Quarzoszillatoren realisieren, deren Quarz einen sogenannten AT-Schnitt aufweist. Derartige Quarze lassen sich aber nur für Frequenzen bis 30 MHz sinnvoll realisieren.

In der Ausführungsform der Fig. 3 wird deshalb ein spannungsgesteuerter Oszillator 66 eingesetzt, der auf einem Drittel der zu erzielenden Frequenz schwing, also auf 12,5 MHz. Um danach auf die gewünschte Frequenz zu kommen, wird diese vervielfacht. In der Ausführungsform wird dazu das Ausgangssignal des Oszillators 66 mit einem Schmitt-Trigger in ein Rechtecksignal umgewandelt, das eine starke dritte Harmonische mit der gewünschten Zielfrequenz aufweist. Durch einen Bandpass-Filter 61 werden die anderen Oberwellen unterdrückt.

Zum anderen weist die Ausführungsform einen Steuereingang auf, über den der Frequenz-Spannungswandler 64 und damit die Regelschleife unterbrochen werden kann. Wird der Ausgang des Frequenz-Spannungswandler 64 durch den Steuereingang in einen hochohmigen Zustand versetzt, hält die Kapazität im Gegenkopplungsast des Integrators 65 den invertierenden Eingang für eine gewisse Zeit auf konstantem Spannungswert, sodass für eine kurze Periode, beispielsweise während des Aussendens eines Anregungspulses die Regelung ausgesetzt werden kann, um Störungen zu vermeiden.

Vorzugsweise erzeugt die Steuerung 23 des Magnetresonanztomographen während des Anregungspulses oder auch während Flanken der Gradienten ein Austastsignal für die Regelschleife.

## Patentansprüche

1. Sendevorrichtung für ein Pilottonsignal zum Einsatz in einer Magnetresonanzvorrichtung, wobei das Pilottonsignal eine Mehrzahl an diskreten Frequenzkomponenten aufweist,
**dadurch gekennzeichnet, dass**
die Sendevorrichtung (60) eine Frequenzstabilisierungseinheit aufweist, wobei die Frequenzstabilisierungseinheit ausgebildet ist, eine Frequenzdifferenz zwischen der Mehrzahl der Frequenzkomponenten konstant zu halten.

2. Sendevorrichtung nach Anspruch 1, wobei die Sendevorrichtung (60) einen Signaleingang für ein erstes Eingangssignal aufweist und die Frequenzstabilisierungseinheit ausgebildet ist, die Frequenzdifferenz der Frequenzkomponenten in Abhängigkeit von dem Eingangssignal zu stabilisieren.

3. Sendevorrichtung nach einem der vorhergehenden Ansprüche, wobei die Frequenzstabilisierungseinheit eine Regelschleife mit einer Frequenz-Offset-Stabilisierung aufweist.

4. Sendevorrichtung nach Anspruch 3, wobei die Frequenz-Offset-Stabilisierung einen Frequenz-Spannungswandler (64), einen Integrator (65) und einen spannungsgesteuerten Oszillator (66) aufweist.

5. Sendevorrichtung nach Anspruch 3 oder 4, wobei die Regelschleife einen Oszillator (66) aufweist, der ausgebildet ist, auf einer Frequenz gleich einem ungeradzahligen Teiler der Frequenz eines Ausgangssignals der Frequenzstabilisierungseinheit zu schwingen.

6. Sendevorrichtung nach einem der Ansprüche 3 bis 5, wobei die Regelschleife einen Steuereingang aufweist, der ausgebildet ist, die Regelschleife derart zu unterbrechen, dass eine Ausgangsfrequenz der Frequenzstabilisierungseinheit für eine Dauer der Unterbrechung weitgehend unverändert bleibt.

7. Magnetresonanztomograph mit einer Sendevorrichtung (60) nach einem der vorhergehenden Ansprüche, wobei die Frequenzkomponenten in einem Empfangsbereich eines Empfängers für Magnetresonanzsignale des Magnetresonanztomographen (1) liegen und der Empfänger ausgebildet ist, das Pilottonsignal mit allen Frequenzkomponenten zu erfassen.

8. Magnetresonanztomograph nach Anspruch 7, wobei der Magnetresonanztomograph (1) ausgebildet ist, der Sendevorrichtung ein Eingangssignal mit einer vorbestimmten Frequenz zuzuführen, sodass das Eingangssignal und die davon abgeleiteten Frequenzkomponenten einen Empfang der Magnetresonanzsignale nicht stören.

9. Magnetresonanztomograph nach Anspruch 7 oder 8 mit einer Sendevorrichtung (60) nach Anspruch 6, wobei der Magnetresonanztomograph (1) ausgebildet ist, während eines Aussendens eines Anregungspulses für Kernspins ein Steuersignal an den Steuereingang anzulegen, das die Regelschleife unterbricht.

## Claims

1. Transmit device for a pilot tone signal for use in a magnetic resonance apparatus, wherein the pilot tone signal has a plurality of discrete frequency components,
**characterised in that**
the transmit device (60) has a frequency stabilisation unit, wherein the frequency stabilisation unit is configured to keep a frequency difference between the plurality of frequency components constant.

2. Transmit device according to claim 1, wherein the transmit device (60) has a signal input for a first input signal and the frequency stabilisation unit is configured to stabilise the frequency difference of the frequency components as a function of the input signal.

3. Transmit device according to one of the preceding claims, wherein the frequency stabilisation unit has a control loop with a frequency offset stabiliser.

4. Transmit device according to claim 3, wherein the frequency offset stabiliser has a frequency-voltage converter (64), an integrator (65), and a voltage-controlled oscillator (66).

5. Transmit device according to claim 3 or claim 4, wherein the control loop has an oscillator (66) which is configured to oscillate at a frequency equal to an odd-numbered divisor of the frequency of an output signal of the frequency stabilisation unit.

6. Transmit device according to one of claims 3 to 5, wherein the control loop has a control input which is configured to interrupt the control loop in such a way that an output frequency of the frequency stabilisation unit remains largely unchanged for the duration of the interruption.

7. Magnetic resonance tomograph having a transmit device (60) according to one of the preceding claims, wherein the frequency components lie in a reception range of a receiver for magnetic resonance signals of the magnetic resonance tomograph (1) and the receiver is configured to acquire the pilot tone signal with all the frequency components.

8. Magnetic resonance tomograph according to claim 7, wherein the magnetic resonance tomograph (1) is configured to supply an input signal of predetermined frequency to the transmit device, such that the input signal and the frequency components derived therefrom do not disrupt reception of the magnetic resonance signals.

9. Magnetic resonance tomograph according to claim 7 or claim 8 having a transmit device (60) according to claim 6, wherein the magnetic resonance tomograph (1) is configured to apply a control signal to the control input during emission of an excitation pulse for nuclear spins to interrupt the control loop.

## Revendications

1. Dispositif d'émission d'un signal pilote à utiliser dans un dispositif de résonnance magnétique, dans lequel le signal pilote a une pluralité de composantes de fréquence discrète,
**caractérisé en ce que**
le dispositif (60) d'émission a une unité de stabilisation de la fréquence, dans lequel l'unité de stabilisation de la fréquence est constituée pour maintenir constante une différence de fréquence entre la pluralité des composantes de fréquence.

2. Dispositif d'émission suivant la revendication 1, dans lequel le dispositif (60) d'émission a une entrée de signal pour un premier signal d'entrée et l'unité de stabilisation de la fréquence est constituée pour stabiliser la différence de fréquence des composantes de fréquence en fonction du signal d'entrée.

3. Dispositif d'émission suivant l'une des revendications précédentes, dans lequel l'unité de stabilisation de la fréquence a une boucle de régulation ayant une stabilisation de décalage de la fréquence.

4. Dispositif d'émission suivant la revendication 3, dans lequel la stabilisation de décalage de la fréquence a un convertisseur (64) fréquence - tension, un intégrateur (65) et un oscillateur (66) commandé en tension.

5. Dispositif d'émission suivant la revendication 3 ou 4, dans lequel la boucle de régulation a un oscillateur (66), qui est constitué pour osciller sur une fréquence égale à un diviseur en nombre impair de la fréquence de signal de sortie de l'unité de stabilisation de la fréquence.

6. Dispositif d'émission suivant l'une des revendications 3 à 5, dans lequel la boucle de régulation a une entrée de commande, qui est constituée pour interrompre la boucle de régulation, de manière à ce qu'une fréquence de sortie de l'unité de stabilisation de la fréquence reste, dans une grande mesure, inchangée pendant la durée de l'interruption.

7. Tomodensitomètre à résonnance magnétique comprenant un dispositif (60) d'émission suivant l'une des revendications précédentes, dans lequel les composantes de fréquence se trouvent dans une plage de réception d'un récepteur de signaux de résonnance magnétique du tomodensitomètre (1) à résonnance magnétique et le récepteur est constitué pour détecter le signal pilote avec toutes les composantes de fréquence.

8. Tomodensitomètre à résonnance magnétique suivant la revendication 7, dans lequel le tomodensitomètre (1) à résonnance magnétique est constitué pour envoyer, au dispositif d'émission, un signal d'entrée ayant une fréquence déterminée à l'avance, de manière à ce que le signal d'entrée et les composantes de fréquence qui s'en déduisent ne perturbent pas une réception des signaux de résonnance magnétique.

9. Tomodensitomètre à résonnance magnétique suivant la revendication 7 ou 8 comprenant un dispositif (60) d'émission suivant la revendication 6, dans lequel le tomodensitomètre (1) à résonnance magnétique est constitué pour appliquer, pendant l'émission d'une impulsion d'excitation de spin de noyau, un signal de commande à l'entrée de commande, qui interrompt la boucle de régulation.
